# FASCICULE DE BREVET EUROPEEN

(11) **EP 1 960 835 B1**
(45) Date de publication et mention de la délivrance du brevet: **17.07.2013**
(21) Numéro de dépôt: 06830321.3
(22) Date de dépôt: 04.12.2006
(51) Int. Cl.: G03F 1/24, G03F 1/54, B82Y 10/00, B82Y 40/00

(54) **MASQUE DE LITHOGRAPHIE EN REFLEXION ET PROCEDE DE FABRICATION DU MASQUE**
REFLEXIONSMASKE FÜR DIE LITHOGRAPHIE UND VERFAHREN ZU IHRER HERSTELLUNG
REFLECTION LITHOGRAPHY MASK AND METHOD FOR MAKING SAME

(30) Priorité: 13.12.2005 FR 0512609
(43) Date de publication de la demande: 27.08.2008
(73) Titulaire: Commissariat à l'Énergie Atomique et aux Énergies Alternatives, 75015 Paris (FR)
(72) Inventeur: CHARPIN-NICOLLE, Christelle, F-38120 Fontanil-Cornillon (FR)
(74) Mandataire: Guérin, Michel
(86) Numéro de dépôt international: PCT/EP2006/069255
(87) Numéro de publication internationale: WO 2007/068614

(56) Documents cités:
- US-A1- 2004 115 960
- PATENT ABSTRACTS OF JAPAN vol. 010, no. 322 (P-511), 31 octobre 1986 (1986-10-31) -& JP 61 128251 A (MITSUBISHI ELECTRIC CORP), 16 juin 1986 (1986-06-16)

## Description

L'invention concerne la photolithographie, et notamment la photolithographie aux très courtes longueurs d'onde. Elle concerne plus précisément une structure de masque de lithographie destinée à être utilisée en réflexion, et un procédé de fabrication de cette structure de masque.

La photolithographie est utilisée pour la réalisation de microstructures électroniques, optiques, mécaniques ou des microstructures combinant des fonctions électroniques et/ou optiques et/ou mécaniques. Elle consiste à insoler par un rayonnement photonique, à travers un masque qui définit le motif souhaité, une couche de résine photosensible déposée sur un substrat plan (par exemple une tranche de silicium). Le développement chimique qui suit l'insolation révèle les motifs souhaités dans la résine. Le motif de résine ainsi gravé peut servir à plusieurs usages, le plus commun étant la gravure d'une couche sous-jacente (isolante ou conductrice ou semiconductrice) pour y définir un motif identique à celui de la résine.

On cherche à obtenir des motifs extrêmement petits et précis et à aligner très précisément des motifs gravés dans de multiples couches superposées. Typiquement, la dimension critique des motifs souhaités est aujourd'hui d'une fraction de micromètre, voire même un dixième de micromètre et au-dessous.

Des tentatives ont été faites pour utiliser des procédés lithographiques n'utilisant pas la lumière mais des bombardements électroniques ou ioniques ; ces procédés sont plus complexes que les procédés de lithographie utilisant des photons à diverses longueurs d'onde (visible, ultraviolet, X). Si on s'en tient à la photolithographie optique, c'est la réduction de la longueur d'onde qui permet de réduire la dimension critique des motifs. La photolithographie en ultraviolet (longueurs d'onde descendant jusqu'à 193 nanomètres) est devenue courante.

On cherche aujourd'hui à descendre très largement au-dessous de ces longueurs d'onde et à travailler en extrême ultraviolet (EUV), à des longueurs d'onde comprises entre 10 et 14 nanomètres et qui sont en pratique des longueurs d'onde de rayons X mous. Le but est d'obtenir une très haute résolution, tout en gardant une ouverture numérique faible et une profondeur de champ suffisante (supérieure à 1 micromètre).

A de telles longueurs d'onde, une particularité du procédé de photolithographie est que le masque d'exposition de la résine fonctionne en réflexion et non en transmission : la lumière en extrême ultraviolet est projetée par une source sur le masque ; le masque comporte des zones absorbantes et des zones réfléchissantes ; dans les zones réfléchissantes, le masque réfléchit la lumière sur la résine à exposer, en y imprimant son image. Le trajet de la lumière entre le masque et la résine à exposer passe par d'autres réflecteurs dont les géométries sont conçues pour projeter une image réduite du masque et non une image en grandeur réelle. La réduction d'image permet de graver sur la résine exposée des motifs plus petits que ceux qui sont gravés sur le masque.

Le masque lui-même est fabriqué à partir d'une photogravure d'une résine, cette fois en transmission, comme on l'expliquera plus loin, et avec une longueur d'onde plus grande, autorisée par le fait que les motifs sont plus grands.

Typiquement, un masque en réflexion est composé d'un substrat plan recouvert d'une structure réfléchissante continue, en pratique un miroir de Bragg, recouverte d'une couche absorbante gravée selon le motif de masquage désiré.

Le miroir doit être aussi réfléchissant que possible à la longueur d'onde de travail prévue pour l'utilisation du masque. La couche absorbante doit être aussi absorbante que possible à cette longueur d'onde ; elle doit pouvoir être déposée sans détérioration de la structure réfléchissante, ce qui implique notamment un dépôt à température pas trop élevée (inférieure à 150°C) ; elle doit aussi pouvoir être gravée sans détérioration de la structure réfléchissante et on prévoit en général une couche tampon entre la couche absorbante et le miroir. La hauteur de l'empilement de la couche tampon et la couche absorbante doit être aussi faible que possible afin de minimiser les effets d'ombrage lorsque l'incidence du rayonnement n'est pas parfaitement normale à la surface du masque.

Pour concilier ces différentes exigences, l'invention propose d'utiliser comme couche absorbante un matériau à base d'indium, soit pur soit sous forme d'un alliage avec d'autres matériaux et de préférence avec du phosphore et/ou de l'arséniure de gallium, et/ou de l'antimoine. Les alliages préférés sont InP, InGaAsP, InSb.

Par conséquent, l'invention propose un masque de photolithographie en extrême ultraviolet (longueurs d'onde comprises entre 10 et 14 nanomètres), fonctionnant en réflexion, comportant un substrat, une structure réfléchissante déposée uniformément sur le substrat, et une couche absorbante pour la longueur d'onde d'utilisation du masque, déposée au-dessus de la structure réfléchissante et gravée selon un motif de masquage désiré, ce masque étant caractérisé en ce que la couche absorbante contient comme constituant absorbant principal de l'indium.

De préférence, une couche tampon (ou couche d'arrêt de gravure) facilitant la gravure sélective de la couche absorbante par rapport à la structure réfléchissante (et empêchant donc la détérioration de cette dernière) est interposée entre la structure réfléchissante et la couche absorbante.

La couche tampon est de préférence à base d'oxyde d'aluminium, tout particulièrement dans le cas où la couche absorbante est en phosphure d'indium.

L'invention est applicable principalement aux masques dits "binaires" dans lesquels le motif est défini simplement par l'absorption forte des rayons extrême-ultraviolets dans les zones comportant la couche absorbante et la réflexion forte dans les zones qui ne comportent pas la couche absorbante. Mais l'invention est applicable aussi aux masques dits à décalage de phase atténués (ou "attenuated phase shift masks" en anglais) dans lesquels le motif est défini non seulement par cette différence d'absorption mais aussi par l'augmentation de contraste due à la différence de phase entre les rayons réfléchis dans les zones absorbantes et les rayons réfléchis dans les zones non absorbantes voisines.

L'invention concerne également, outre le masque lui-même, un procédé de fabrication de masque de photolithographie en réflexion en extrême ultraviolet (longueurs d'onde comprises entre 10 et 14 nanomètres), dans lequel on dépose, sur un substrat revêtu d'une structure réfléchissante pour la longueur d'onde d'utilisation du masque, une couche absorbante pour cette longueur d'onde, puis une résine de photolithographie, on insole la résine selon un motif d'exposition désiré, on développe la résine, et on grave la couche absorbante à travers le motif de résine subsistant, pour définir un motif de zones qui sont absorbantes à la longueur d'onde d'utilisation du masque, caractérisé en ce que la couche absorbante est une couche à base d'indium comme constituant absorbant principal de la couche.

Parmi les avantages de l'indium, et tout particulièrement du phosphure d'indium, on a également le fait que sa réflectivité est faible en ultraviolet profond ("deep ultraviolet" en anglais) à 257 nanomètres ; or cette faible réflectivité est utile pour l'inspection optique du masque à cette longueur d'onde en vue de découvrir des défauts éventuels de la couche absorbante.

L'invention sera mieux comprise à l'aide d'exemples de réalisation de masques fonctionnant en extrême ultraviolet et leurs procédés de fabrication selon l'invention en référence aux figures indexées dans lesquelles :
- la figure 1 représente un masque de l'état de l'art, fonctionnant par réflexion, de type binaire ;
- les figures 2a à 2d et 3a à 3e représentent les principales étapes de fabrication d'un masque selon l'invention fonctionnant par réflexion EUV.

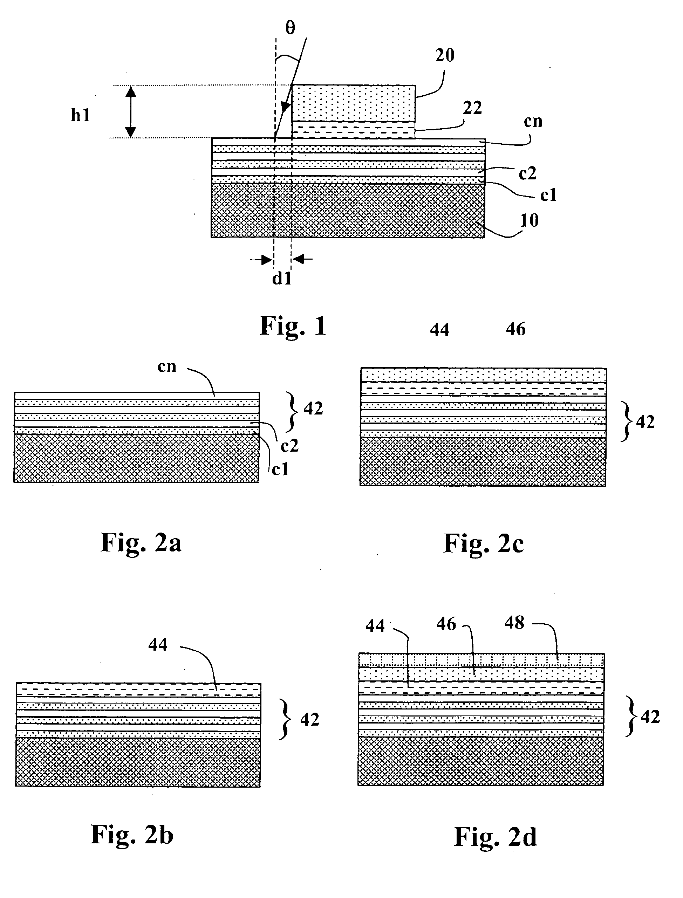

La figure 1 représente un masque de photolithographie "binaire" de l'art antérieur, fonctionnant en réflexion en extrême ultraviolet. Il est composé d'un substrat plan 10 recouvert d'une structure réfléchissante continue. La structure réfléchissante est une superposition de couches c1, c2, ...cn, transparentes à la longueur d'onde extrême ultraviolet à laquelle le masque sera utilisé en réflexion. Les couches sont des couches alternées d'indice optique différents et leurs épaisseurs sont choisies en fonction des indices et de la longueur d'onde d'utilisation pour constituer un miroir de Bragg de fort coefficient de réflexion à cette longueur d'onde.

Le miroir de Bragg ainsi constitué est revêtu d'une couche absorbante 20 pour cette longueur d'onde et cette couche est gravée selon le motif de masquage désiré. Ce motif est géométriquement dans un rapport plus grand que 1 (typiquement un rapport 4) avec le motif que le masque projettera en cours d'utilisation sur une couche à graver.

Une couche tampon 22 est en principe prévue entre la couche absorbante et la structure réfléchissante. Elle participe éventuellement à l'absorption mais elle sert surtout de couche d'arrêt de gravure pendant la photogravure de la couche absorbante.

Dans l'art antérieur, les matériaux utilisés comme couche absorbante sont typiquement des métaux tels que le titane, le tantale, le tungstène, le chrome, ou l'aluminium, et également des composés de ces métaux tels que le siliciure de tantale, le nitrure de titane, le titane-tungstène,

L'épaisseur de l'empilement de la couche tampon et la couche absorbante est relativement élevée dès lors qu'on veut obtenir une absorption suffisante (réflexion inférieure à 0,5%). Par exemple, il faut typiquement 70 nm de chrome sur 90 nm de couche tampon de silice ;

Cette hauteur globale est importante et aboutit à des effets d'ombrage non négligeables comme l'illustre la figure 1 : des rayons arrivant en oblique sous une incidence θ (même faible) sont masqués sur une distance d1 qui détériore la résolution lors de l'utilisation du masque. Pour une incidence donnée, la distance d1 est d'autant plus grande que la hauteur h1 de l'empilement est plus grande.

Selon l'invention, on a trouvé qu'on pouvait utiliser de l'indium comme constituant principal de la couche absorbante, seul ou en alliage avec d'autres composés, tout en respectant des contraintes importantes telles que le dépôt à basse température pour ne pas détériorer la structure réfléchissante sous jacente. On constate alors qu'on peut se contenter d'une hauteur d'empilement absorbant beaucoup plus faible, par exemple de 40 nanomètres environ, ce qui réduit les effets d'ombrage.

La couche absorbante préférée est un alliage InP : phosphure d'indium. D'autres alliages sont utilisables, et notamment InGaAsP et InSb.

Tout particulièrement lorsque la couche absorbante est en phosphure d'indium, la couche tampon ou couche d'arrêt de gravure est de préférence de l'alumine Al₂O₃- Ce peut être aussi de la silice SiO2, ou encore un empilement alterné d'alumine et de chrome.

On peut envisager que la couche absorbante soit composée d'un empilement d'au moins une couche à base d'indium et d'une autre couche à base d'un matériau utilisé dans l'art antérieur tel que le titane ou le tantale ou le chrome, etc.).

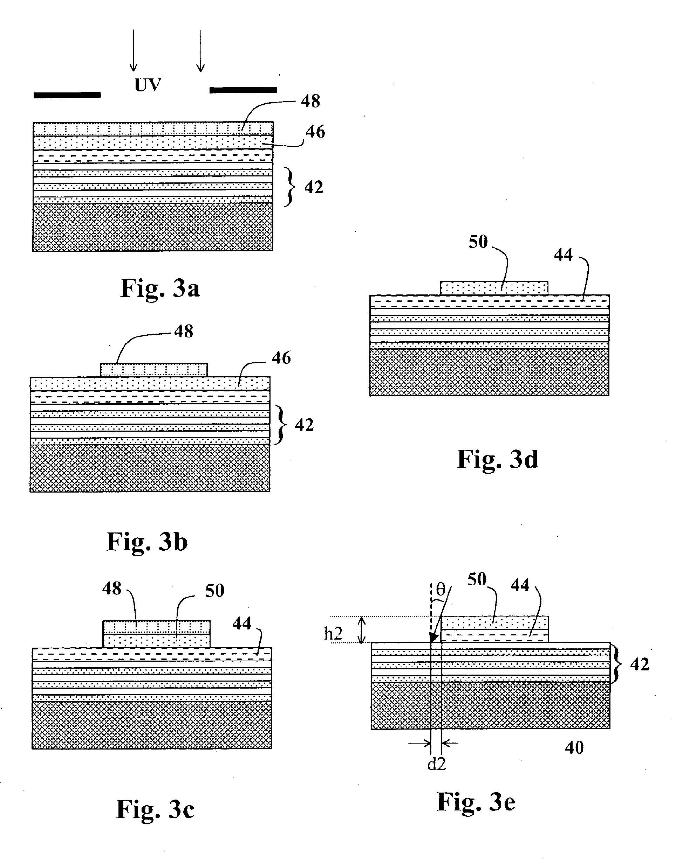

On va maintenant décrire dans ses grandes lignes le procédé de réalisation du masque, en référence aux figures 2a à 2d et 3a à 3e.

Les principales étapes sont les suivantes :
- dépôt sur un substrat plan 40 d'une structure réfléchissante pour la longueur d'onde d'utilisation du masque en extrême ultraviolet ; la structure est un empilement 42 d'une alternance de couches transparentes c1, c2,...cn d'indices différents et d'épaisseurs choisies en fonction des indices pour constituer une structure réfléchissante de type miroir de Bragg (figure 2a) ;
- dépôt d'une couche tampon 44 ayant un rôle de couche d'arrêt de gravure qu'on expliquera plus loin (figure 2b) ;
- dépôt, sur la couche tampon, d'une couche de matériau à base d'indium 46 (figure 2c) en vue de réaliser l'élément absorbant du masque pour les longueurs d'onde en extrême ultraviolet ;
- étalement d'une résine photosensible 48 sur la couche de matériau à base d'indium (figure 2d) ;
- réalisation, par photolithographie en ultraviolet dans la résine, d'un motif correspondant au motif de masque à réaliser (figures 3a et 3b) ; la longueur d'onde d'insolation en ultraviolet n'est pas de l'extrême ultraviolet, c'est une longueur d'onde beaucoup plus grande à laquelle la résine est sensible, par exemple environ 248 nanomètres ; une insolation par faisceau d'électrons sur une résine sensible à ce type de faisceau est aussi possible ;
- gravure de la couche de matériaux à base d'indium (figure 3c) faisant apparaître un motif de zones absorbantes 50 ; la gravure est interrompue lorsque la couche tampon 44 commence à être attaquée, ce qui indique que toute l'épaisseur de la couche à base d'indium a été enlevée là où elle doit être enlevée ;
- élimination de la résine photosensible 48 (figure 3d) ;
- gravure de la couche tampon 44 faisant apparaître la structure réfléchissante entré les zones absorbantes 50 du masque qui est maintenant terminé (figure 3e).

Le rôle de la couche tampon est de protéger la surface de la structure réfléchissante lors de la gravure de la couche de matériau à base d'indium. En effet, les produits d'attaque de la couche à base d'indium risqueraient d'endommager les couches superficielles de la structure réfléchissante en fin d'attaque de cette couche et ceci n'est pas acceptable, la qualité de la structure réfléchissante étant essentielle. La couche tampon est attaquée plus lentement que la couche absorbante par les produits de gravure de cette dernière. Par ailleurs la couche tampon doit pouvoir être gravée sélectivement par rapport à la couche supérieure du miroir de Bragg afin que cette couche supérieure ne soit pas attaquée lors de la gravure de la couche tampon.

L'utilisation d'un matériau à base d'indium pour la réalisation de la couche absorbante réduit les effets d'ombrage sur la surface du revêtement réflecteur du masque. En effet, les qualités d'absorption de l'indium pour les longueurs d'onde envisagée (10 à 14 nanomètres, et tout particulièrement entre 13 et 14 nanomètres) sont telles qu'on peut utiliser une couche absorbante ayant une épaisseur d'une vingtaine de nanomètres et non une soixantaine ou plus. D'autre part, compte-tenu des produits d'attaque utilisés pour graver la couche absorbante, on peut prévoir que la couche tampon a une épaisseur également de l'ordre de 20 nanomètres ; c'est le cas en particulier si la couche absorbante est en phosphure d'indium et si la couche tampon est en alumine. En réduisant l'épaisseur de la couche absorbante et de la couche tampon, donc l'épaisseur totale h2 de l'empilement absorbant, on réduit les effets d'ombrage à une distance latérale d2 (figure 3e) plus petite que d1 (figure 1) pour un même angle d'incidence θ.

On notera que la couche tampon, tout particulièrement si elle comprend de l'alumine, peut servir de couche réfléchissante pour l'inspection "visuelle" des défauts de la couche absorbante, inspection qui se fait en ultraviolet profond "deep UV" à 257 nanomètres.

La couche tampon peut être aussi en silice ou être constituée par un empilement de plusieurs couches, par exemple des couches de chrome et d'oxyde d'aluminium.

Dans une variante du procédé de fabrication du masque fonctionnant par réflexion selon l'invention, la couche absorbante comporte une ou plusieurs couches métalliques, par exemple la couche absorbante peut être réalisée par un empilement de couches de matériau à base d'indium et d'au moins une couche métallique ; la couche métallique peut être en titane, tantale, tungstène, chrome, ruthénium.

On va maintenant décrire un exemple de réalisation détaillé de la procédure de fabrication du masque selon l'invention :
- réalisation d'un revêtement réflecteur sur le substrat, par pulvérisation par faisceau d'ions ou « lon Beam Sputtering » en langue anglaise : on pulvérise sur le substrat plusieurs dizaines de paires de couches transparentes, par exemple 40 paires, chaque paire comportant une couche en molybdène et une couche en silicium ; l'épaisseur totale de chaque paire est d'environ 6,9 nanomètres pour une réflexion optimale à une longueur d'onde d'environ 13,8 nanomètres ; le coefficient de réflexion dépasse alors 60% et peut atteindre même 75% ; les paires de couches peuvent aussi être des paires molybdène/béryllium ou ruthénium/béryllium ; le substrat peut être une tranche de silicium ou une plaque de verre ou de quartz de 200 mm de diamètre ; la planéité du substrat doit être élevée, et il est préférable que les imperfections de planéité ne dépassent pas 0,4 micromètre pour une tranche de ce diamètre ; le dépôt par pulvérisation est fait de préférence à une température d'environ 50°C ;
- dépôt sur le revêtement réflecteur d'une couche tampon en oxyde d'aluminium Al₂O₃ d'une épaisseur d'environ 20 nanomètres. Le dépôt de cette couche d'arrêt s'effectue par un procédé de dépôt chimique de couches atomiques en phase vapeur ou « Atomic Layer Chemical Vapor Deposition » en langue anglaise, à une température de 120 °C qui est acceptable pour la structure réfléchissante sous-jacente ;
- dépôt à basse température (inférieure à 100°C) sur la couche tampon, d'une couche absorbante en extrême ultraviolet, à base d'InP, d'environ 20 nanomètres d'épaisseur, en utilisant une machine d'épitaxie par jets moléculaires ;
- étalement sur la couche absorbante d'une résine lithographique telle que la résine de type PMMA (polyméthylméthacrylate) commercialisée par la société de nom commerciale « Rhom & Haas Electronics Materials » ou RHEM ;
- réalisation dans la résine, par lithographie UV (à 248 nanomètres par exemple) ou par lithographie par faisceau d'électrons, d'un motif désiré ;
- gravure, par plasma par exemple, du matériau à base d'indium à une température de l'ordre de 100°C, par exemple avec une chimie Cl₂/Ar, pour enlever la couche absorbante là où elle n'est pas protégée par la résine ; les gaz de gravure plasma dépendent du matériau à graver ; la couche tampon protège le miroir de Bragg à la fin de cette gravure ;
- enlèvement de la résine par exemple en deux étapes, retrait à sec ou « stripping » en langue anglaise, suivi d'un retrait humide, par exemple par traitement EKC 265, le produit EKC 265 étant commercialisé par la société de nom commercial « EKC » et correspondant à la résine indiquée ci-dessus ; la température atteinte est comprise entre 65°C et 70°C, ce qui est acceptable ; le « stripping » sec est fait à partir d'argon, d'oxygène et de CF₄. ; la température atteinte lors du « stripping » sec est comprise entre 54°C et 60°C, ce qui est acceptable.
- élimination de la couche tampon là où elle n'est pas protégée par la couche absorbante d'InP, pour mettre à nu localement le revêtement réflecteur. Cette étape peut être, par exemple dans le cas d'une couche d'arrêt en Al₂O₃, une gravure chimique FH en solution à 1%, qui n'attaque pas la couche absorbante et qui ne détériore pas la structure réfléchissante sous-jacente ;

Le masque ainsi réalisé selon l'invention ayant fait l'objet d'essais et simulations, présente les caractéristiques suivantes :l'indice d'absorption dans les EUV (à 13,5 nanomètres) de l'InP est de 0,0568. Cet indice obtenu est meilleur que ceux des matériaux utilisés dans l'état de l'art tels que le TaN qui présente un indice d'absorption de 0,044 et le chrome qui a un indice de 0,0383. L'indium a un indice d'absorption de 0,07.

Par simulation, la réflectivité de l'empilement de la couche à base de InP de 20 nanomètres et de la couche de Al₂O₃ de 20 nanomètres a été trouvée inférieure à 0,5% pour un éclairement dans les EUV (13,5 nanomètres). Le logiciel utilisé pour la simulation est le logiciel « xop ».

Le masque fonctionnant en réflexion des EUV donne satisfaction avec une épaisseur (h2) d'empilement absorbant nettement inférieure à celle des masques de l'état de l'art puisqu'une épaisseur globale de 40 nanomètres suffit, bien inférieure à l'épaisseur de 160 nanomètres de l'état de l'art (70nm de Cr et 90nm de silice).

L'invention a été décrite en détail à propos d'un masque binaire mais peut aussi être utilisée pour la réalisation d'un masque à décalage de phase atténué dans lequel la couche absorbante joue non seulement un rôle d'absorbant mais aussi un rôle de déphaseur de la fraction de lumière qu'elle réfléchit.

## Revendications

1. Masque de photolithographie en extrême ultraviolet, fonctionnant en réflexion, comportant un substrat (10, 12, 40), une structure réfléchissante (16, 42) déposée uniformément sur le substrat, et une couche absorbante (20, 22, 50) pour la longueur d'onde d'utilisation du masque, déposée au-dessus de la structure réfléchissante et gravée selon un motif de masquage désiré, **caractérisé en ce que** la couche absorbante contient, comme constituant absorbant principal, de l'indium.

2. Masque de photolithographie selon la revendication 1, **caractérisé en ce que** la couche absorbante est un matériau à base d'indium choisi parmi les matériaux suivants : InP, InGaAsP, InSb.

3. Masque de photolithographie selon l'une des revendications 1 et 2, **caractérisé en ce que** la couche absorbante est réalisée par un empilement de couches de matériau à base d'indium et d'au moins une couche métallique, le métal étant choisi notamment parmi le titane, le tantale, le chrome.

4. Masque de photolithographie selon l'une des revendications 1 à 3, **caractérisé en ce qu'**une couche tampon (44), facilitant la gravure sélective de la couche absorbante par rapport à la structure réfléchissante, est interposée entre la structure réfléchissante et la couche absorbante.

5. Masque de photolithographie selon la revendication 4 **caractérisé en ce que** la couche tampon est une couche d'oxyde d'aluminium Al₂O₃ ou de silice.

6. Masque de photolithographie selon la revendication 4, **caractérisé en ce que** la couche tampon est un empilement de plusieurs couches, notamment de chrome et d'oxyde d'aluminium.

7. Masque de photolithographie selon la revendication 5, **caractérisé en ce que** dans un empilement couche absorbante en InP/ couche tampon en Al₂O₃, la couche absorbante en InP a une épaisseur d'environ 20 nanomètres, la couche tampon en Al₂O₃ a une épaisseur d'environ 20 nanomètres.

8. Procédé de fabrication de masque de photolithographie en réflexion en extrême ultraviolet, dans lequel on dépose sur un substrat revêtu d'une structure (42) réfléchissante à la longueur d'onde d'utilisation du masque, une couche (46) absorbante pour cette longueur d'onde, puis une résine de photolithographie (48), on insole la résine selon un motif d'exposition désiré, on développe la résine, et on grave la couche absorbante à travers le motif de résine subsistant, pour définir un motif de zones qui sont absorbantes à la longueur d'onde d'utilisation du masque, **caractérisé en ce que** la couche absorbante est une couche à base d'indium comme constituant absorbant principal de la couche.

9. Procédé selon la revendication 8, **caractérisé en ce qu'**il comporte les étapes suivantes :
- dépôt sur un substrat (40) d'une structure réfléchissante constituée par un empilement (42) d'une alternance de couches transparentes à la longueur d'onde d'utilisation du masque (c1, c2,...cn) d'indices différents ;
- dépôt de la couche tampon (44) ;
- dépôt, sur la couche tampon, de la couche absorbante à base d'indium (46) ;
- étalement d'une résine lithographique (48) sur la couche à base d'indium ;
- réalisation, par lithographie en ultraviolet ou par faisceau d'électrons, d'un motif de résine désiré ;
- gravure par plasma de la couche à base d'indium là où elle n'est pas protégée par la résine (50) ;
- élimination de la résine subsistante et gravure de la couche tampon (44) là où elle n'est pas protégée par la couche absorbante.

10. Procédé selon la revendication 9, **caractérisé en ce que** l'étape de photolithographie de la résine est effectuée avec un rayonnement ultraviolet de longueur d'onde très supérieure à la longueur d'onde d'utilisation du masque.

11. Procédé selon l'une des revendications 8 à 10, **caractérisé en ce que** la structure réfléchissante est réalisée par pulvérisation par faisceau d'ions de plusieurs dizaines de paires de couches , l'épaisseur globale de chaque paire étant d'environ 6,9 nanomètres.

12. Procédé selon l'une des revendications 8 à 11, **caractérisé en ce que** la couche absorbante est en InP d'une épaisseur d'environ 20 nanomètres et la couche tampon en oxyde d'aluminium Al₂O₃ d'une épaisseur d'environ 20 nanomètres..

13. Procédé selon l'une des revendications 8 à 12, **caractérisé en ce que** la couche absorbante est réalisée par dépôt à basse température, inférieure à 100°C, d'une couche à base de phosphure d'indium.

## Patentansprüche

1. Fotolithografische Maske im extremen Ultraviolett, die mit Reflexion arbeitet, umfassend ein Substrat (10, 12, 40), eine gleichmäßig auf das Substrat abgesetzte reflektierende Struktur (16, 42) und eine absorbierende Schicht (20, 22, 50) für die Nutzungswellenlänge der Maske, die auf der reflektierenden Struktur abgesetzt und mit einem gewünschten Maskierungsmuster geätzt ist, **dadurch gekennzeichnet, dass** die absorbierende Schicht als absorbierenden Hauptbestandteil Indium enthält.

2. Fotolithografische Maske nach Anspruch 1, **dadurch gekennzeichnet, dass** die absorbierende Schicht aus einem Material auf Indiumbasis ist, ausgewählt aus den folgenden Materialien: InP, InGaAsP, InSb.

3. Fotolithografische Maske nach einem der Ansprüche 1 und 2, **dadurch gekennzeichnet, dass** die absorbierende Schicht durch einen Stapel von Schichten aus Material auf Indiumbasis und wenigstens einer metallischen Schicht realisiert ist, wobei das Metall insbesondere aus Titan, Tantal und Chrom ausgewählt ist.

4. Fotolithografische Maske nach einem der Ansprüche 1 bis 3, **dadurch gekennzeichnet, dass** eine Pufferschicht (44), die das selektive Ätzen der absorbierenden Schicht mit Bezug auf die reflektierende Struktur erleichtert, zwischen der reflektierenden Struktur und der absorbierenden Schicht vorgesehen ist.

5. Fotolithografische Maske nach Anspruch 4, **dadurch gekennzeichnet, dass** die Pufferschicht eine Aluminiumoxidschicht Al₂O₃ oder eine Kieselerdeschicht ist.

6. Fotolithografische Maske nach Anspruch 4, **dadurch gekennzeichnet, dass** die Pufferschicht ein Stapel von mehreren Schichten, insbesondere aus Chrom und Aluminiumoxid ist.

7. Fotolithografische Maske nach Anspruch 5, **dadurch gekennzeichnet, dass** in einem Stapel aus absorbierender InP-Schicht und Al₂O₃-Pufferschicht die absorbierende InP-Schicht eine Dicke von etwa 20 Nanometern und die Al₂O₃-Pufferschicht eine Dicke von etwa 20 Nanometern hat.

8. Verfahren zur Herstellung einer fotolithografischen Reflexionsmaske aus extremem Ultraviolett, bei dem auf ein Substrat mit einer Struktur (42), die bei der Nutzungswellenlänge der Maske reflektiert, eine Schicht (46), die für diese Wellenlänge absorptionsfähig ist, dann ein fotoüthografisches Harz (48) abgesetzt wird, das Harz mit einem gewünschten Belichtungsmuster belichtet wird, das Harz entwickelt und die absorbierende Schicht durch das darunterliegende Harzmuster geätzt wird, um ein Muster von Zonen zu definieren, die bei der Nutzungswellenlänge der Maske absorptionsfähig sind, **dadurch gekennzeichnet, dass** die absorbierende Schicht eine Schicht auf Indiumbasis als absorbierenden Hauptbestandteil der Schicht ist.

9. Verfahren nach Anspruch 8, **dadurch gekennzeichnet, dass** es die folgenden Schritte beinhaltet:
- Absetzen einer reflektierenden Schicht, die durch einen Stapel (42) von abwechselnden transparenten Schichten mit der Nutzungswellenlänge der Maske (c1, c2, ... cn) mit verschiedenen Indexen gebildet wird, auf ein Substrat (40);
- Absetzen der Pufferschicht (44);
- Absetzen der absorbierenden Schicht auf Indiumbasis (46) auf die Pufferschicht;
- Ausbreiten eines lithografischen Harzes (48) auf der Schicht auf Indiumbasis;
- Realisieren, durch Ultraviolett-Lithografie oder durch Elektronenstrahlen, eines gewünschten Harzmusters;
- Plasmaätzen der Schicht auf Indiumbasis dort, wo sie nicht durch das Harz (40) geschützt wird;
- Entfernen des darunterliegenden Harzes und Ätzen der Pufferschicht (44) dort, wo sie nicht durch die absorbierende Schicht geschützt wird.

10. Verfahren nach Anspruch 9, **dadurch gekennzeichnet, dass** der Fotolithografieschritt des Harzes mit einer ultravioletten Strahlung mit einer weitaus größeren Wellenlänge als der Nutzungswellenlänge der Maske erfolgt.

11. Verfahren nach einem der Ansprüche 8 bis 10, **dadurch gekennzeichnet, dass** die reflektierende Struktur durch Pulverisieren durch Ionenstrahlen von mehreren Dutzend Schichtpaaren erfolgt, wobei die globale Dicke jedes Paares etwa 6,9 Nanometer beträgt.

12. Verfahren nach einem der Ansprüche 8 bis 11, **dadurch gekennzeichnet, dass** die absorbierende Schicht aus InP mit einer Dicke von etwa 20 Nanometern ist und die Pufferschicht aus Aluminiumoxid Al₂O₃ mit einer Dicke von etwa 20 Nanometern ist.

13. Verfahren nach einem der Ansprüche 8 bis 12, **dadurch gekennzeichnet, dass** die absorbierende Schicht durch Absetzen einer Schicht auf Indiumphosphidbasis bei einer niedrigen Temperatur unter 100°C erfolgt.

## Claims

1. An extreme ultraviolet photolithography mask, operating in reflection, comprising a substrate (10, 12, 40), a reflecting structure (16, 42) deposited uniformly on the substrate, and an absorbent layer (20, 22, 50) which is absorbent at the operating wavelength of the mask and is deposited on top of the reflecting structure and etched in a desired masking pattern, **characterized in that** the absorbent layer contains indium as principal absorbent constituent.

2. The photolithography mask as claimed in claim 1, **characterized in that** the absorbent layer is an indium-based material chosen from the following materials: InP, InGaAsP and InSb.

3. The photolithography mask as claimed in either of claims 1 and 2, **characterized in that** the absorbent layer is produced by a stack of indium-based layers and of at least one metallic layer, the metal being chosen notably from titanium, tantalum and chromium.

4. The photolithography mask as claimed in one of claims 1 to 3, **characterized in that** a buffer layer (44), facilitating the selective etching of the absorbent layer relative to the reflecting structure, is interposed between the reflecting structure and the absorbent layer.

5. The photolithography mask as claimed in claim 4, **characterized in that** the buffer layer is a layer of aluminum oxide (Al₂O₃) or silica.

6. The photolithography mask as claimed in claim 4, **characterized in that** the buffer layer is a stack of several layers, notably chromium and aluminum oxide layers.

7. The photolithography mask as claimed in claim 5, **characterized in that**, in an InP absorbent layer/Al₂O₃ buffer layer stack, the InP absorbent layer has a thickness of about 20 nanometers and the Al₂O₃ buffer layer has a thickness of about 20 nanometers.

8. A process for fabricating an extreme ultraviolet reflection photolithography mask, in which there are deposited, on a substrate coated with a reflecting structure (42) which is reflective at the operating wavelength of the mask, an absorbent layer (46) which is absorbent at this wavelength followed by a photolithography resist (48), the resist is irradiated in a desired exposure pattern, the resist is developed and the absorbent layer is etched through the resist pattern remaining, so as to define a pattern of zones that are absorbent at the operating wavelength of the mask, **characterized in that** the absorbent layer is a layer based on indium as principal absorbent constituent of the layer.

9. The process as claimed in claim 8, **characterized in that** it comprises the following steps:
- deposition of a reflecting structure, consisting of a stack (42) of an alternation of layers (c1, c2, ... cn) that are transparent at the operating wavelength of the mask and have different indices, on a substrate (40);
- deposition of a buffer layer (44);
- deposition of the indium-based absorbent layer (46) on the buffer layer;
- spreading of a lithography resist (48) on the indium-based layer;
- production of a desired resist pattern by ultraviolet or electron-beam lithography;
- plasma etching of the indium-based layer just where it is not protected by the resist (50); and
- removal of the remaining resist and etching of the buffer layer (44) just where it is not protected by the absorbent layer.

10. The process as claimed in claim 9, **characterized in that** the resist photolithography step is carried out with ultraviolet radiation at a wavelength much longer than the operating wavelength of the mask.

11. The process as claimed in one of claims 8 to 10, **characterized in that** the reflecting structure is produced by the ion beam sputtering of several tens of pairs of layers, the overall thickness of each pair being about 6.9 nanometers.

12. The process as claimed in one of claims 8 to 11, **characterized in that** the absorbent layer is made of InP with a thickness of about 20 nanometers and the buffer layer is made of aluminum oxide (Al₂O₃) with a thickness of about 20 nanometers.

13. The process as claimed in one of claims 8 to 12, **characterized in that** the absorbent layer is produced by low-temperature deposition (below 100°C) of a layer based on indium phosphide.
